# EUROPEAN PATENT APPLICATION

(11) **EP 2 575 177 A2**
(43) Date of publication of application: **03.04.2013**
(21) Application number: 12178082.9
(22) Date of filing: 26.07.2012
(51) Int. Cl.: H01L 29/66

(54) **Manufacturing method of compound semiconductor device**

(30) Priority: 29.09.2011 JP 2011215107
(71) Applicant: FUJITSU LIMITED, Kawasaki-shi, Kanagawa 211-8588 (JP)
(72) Inventor: Minoura, Yuichi, Kawasaki-shi, Kanagawa 211-8588 (JP); Okamoto, Naoya, Kawasaki-shi, Kanagawa 211-8588 (JP); Kikkawa, Toshihide, Kawasaki-shi, Kanagawa 211-8588 (JP); Makiyama, Kozo, Kawasaki-shi, Kanagawa 211-8588 (JP); Ohki, Toshihiro, Kawasaki-shi, Kanagawa 211-8588 (JP)
(74) Representative: Holz, Ulrike

(57) **Abstract**

A passivation film is formed on a compound semiconductor layered structure, an electrode formation scheduled position for the passivation film is thinned by dry etching, a thinned portion of the passivation film is penetrated by wet etching to form an opening, and a gate electrode is formed on the passivation film so as to embed this opening by an electrode material.

## Description

### FIELD

The embodiments discussed herein are directed to a manufacturing method of a compound semiconductor device.

### BACKGROUND

There is considered application of a nitride semiconductor to a semiconductor device with high withstand voltage and high output, utilizing characteristics such as high saturation electron speed and wide band gap. For example, the band gap of GaN as a nitride semiconductor is 3.4 eV, which is larger than the band gap of Si (1.1 eV) and the band gap of GaAs (1.4 eV), and thus GaN has high breakdown electric field intensity. Accordingly, GaN is quite promising as a material of a semiconductor device for power supply which obtains high voltage operation and high output.

As a semiconductor device using the nitride semiconductor, there have been made numerous reports on a field effect transistor, particularly a high electron mobility transistor (HEMT). For example, among GaN-based HEMTs (GaN-HEMTs), AlGaN/GaN · HEMT using GaN as an electron transit layer and AlGaN as an electron supply layer is attracting attention. In the AlGaN/GaN · HEMT, a strain resulted from a lattice constant difference between GaN and AlGaN occurs in AlGaN. Two-dimensional electron gas (2DEG) of high concentration is obtained from piezoelectric polarization and spontaneous polarization of AlGaN caused by the strain. Accordingly, the AlGaN/GaN · HEMT is expected as a high efficiency switch element and a high withstand voltage electric power device for electric vehicle, or the like.

[Non-patent Document 1] D. Song et.al., IEEE Electron Device Lett., vol. 28, no. 3, pp. 189-191, 2007

To produce the semiconductor device using the nitride semiconductor, a protective film (for example, a silicon nitride (SiN)) covering the surface of a compound semiconductor layered structure is formed, and thereafter an opening is made in an insulating film for forming an electrode. As a method for this opening, dry etching or wet etching has been used hitherto.

The dry etching is suitable for forming a desired minute form. Further, it is known that a predetermined gas species of etching gas used for the dry etching can vary the conduction band of the nitride semiconductor and reduces leak current of the semiconductor device using the nitride semiconductor. By using the dry etching for forming an opening in the protective film, it is expected that a desired minute opening for forming a minute electrode is formed, and moreover leak current is reduced.

However, on the other hand, when the dry etching is applied to formation of electrode in the nitride semiconductor, the surface of a compound semiconductor layer is exposed to plasma and the like of the etching, and escape of nitrogen occurs in the compound semiconductor crystal. Thus, there is a problem of occurrence of donor due to generation of nitrogen pores, and further giving rise to increase in leak current accompanying the occurrence of donor.

The wet etching is suitable when it is desired to avoid damage due to plasma and the like. By using the wet etching for forming the opening in the protective film, leak current can be suppressed without allowing escape of nitrogen to occur in the compound semiconductor crystal.

However, on the other hand, when the wet etching is applied to formation of electrode in the nitride semiconductor, there is a problem that a desired minute opening for forming a minute electrode cannot be formed. Further, the reduction effect of leak current as obtained with the gas species of the dry etching cannot be expected.

Thus, when producing the semiconductor device using the nitride semiconductor, problems as described above arise by using either of the dry etching and the wet etching when the opening for forming the electrode in the protective film is formed. Accordingly, the current situation is that various measures are sought for.

### SUMMARY

It is desirable to provide a manufacturing method of a compound semiconductor device capable of achieving a highly reliable, high withstand voltage compound semiconductor device in which leak current is suppressed even though a desired minute opening is formed in an insulating film on a compound semiconductor layered structure.

According to an embodiment of an aspect of the invention, there is provided a manufacturing method of a compound semiconductor device includes forming an insulating film on a compound semiconductor layer, thinning a predetermined portion of the insulating film by dry etching, and penetrating a thinned predetermined portion of the insulating film by wet etching.

According to an embodiment of another aspect of the invention, there is provided a compound semiconductor device, comprising a compound semiconductor layer, an insulating film which is formed on the compound semiconductor layer and has a through hole; and an electrode formed in the through hole, wherein the compound semiconductor layer has a fluorine containing region which contains fluorine in a portion under the electrode.

According to an embodiment of another aspect of the invention, there is provided a power supply circuit comprising a transformer, and a high-voltage circuit and a low-voltage circuit with the transformer being interposed therebetween, wherein: the high-voltage circuit has a transistor and a diode; at least one of the transistor and the diode comprises: a compound semiconductor layer, an insulating film which is formed on the compound semiconductor layer and has a through hole, and an electrode formed in the through hole; and the compound semiconductor layer has a fluorine containing region which contains fluorine in a portion under the electrode.

According to an embodiment of another aspect of the invention, there is provided a high frequency amplifier which amplifies and outputs an inputted high frequency voltage, the high frequency amplifier having a transistor, wherein: the transistor comprises: a compound semiconductor layer, an insulating film which is formed on the compound semiconductor layer and has a through hole, and an electrode formed in the through hole; and the compound semiconductor layer has a fluorine containing region which contains fluorine in a portion under the electrode.

### BRIEF DESCRIPTION OF DRAWINGS

Reference is made, by way of example only, to the accompanying drawings, in which:
Fig. 1A to Fig. 1C are schematic cross-sectional views illustrating a manufacturing method of AlGaN/GaN · HEMT according to a first embodiment in the order of steps;
Fig. 2A and Fig. 2B are schematic cross-sectional views illustrating the manufacturing method of AlGaN/GaN · HEMT according to the first embodiment in the order of steps, continued from Fig. 1C;
Fig. 3A and Fig. 3B are schematic cross-sectional views illustrating the manufacturing method of AlGaN/GaN · HEMT according to the first embodiment in the order of steps, continued from Fig. 2B;
Fig. 4 is a characteristic diagram illustrating results of checking leak current which occurs with respect to a Schottky type AlGaN/GaN · HEMT according to the first embodiment and comparative examples 1, 2;
Fig. 5A to Fig. 5C are schematic cross-sectional views illustrating a manufacturing method of a GaN-SBD according to a second embodiment in the order of steps;
Fig. 6A to Fig. 6C are schematic cross-sectional views illustrating the manufacturing method of the GaN-SBD according to the second embodiment in the order of steps, continued from Fig. 5C;
Fig. 7 is a connection diagram illustrating a PFC circuit according to a third embodiment;
Fig. 8 is a connection diagram illustrating a schematic structure of a power supply device according to a fourth embodiment; and
Fig. 9 is a connection diagram illustrating a schematic structure of a high frequency amplifier according to a fifth embodiment.

### DESCRIPTION OF EMBODIMENTS

Hereinafter, specific embodiments of a manufacturing method of a compound semiconductor device will be described in detail using drawings. It should be noted that, in consideration of easiness of understanding, certain diagrams of the drawings are drawn with a film thickness and so on of component members thereof being different from actual values.

### -First Embodiment-

In this embodiment, as the compound semiconductor device, a nitride semiconductor AlGaN/GaN · HEMT will be disclosed.

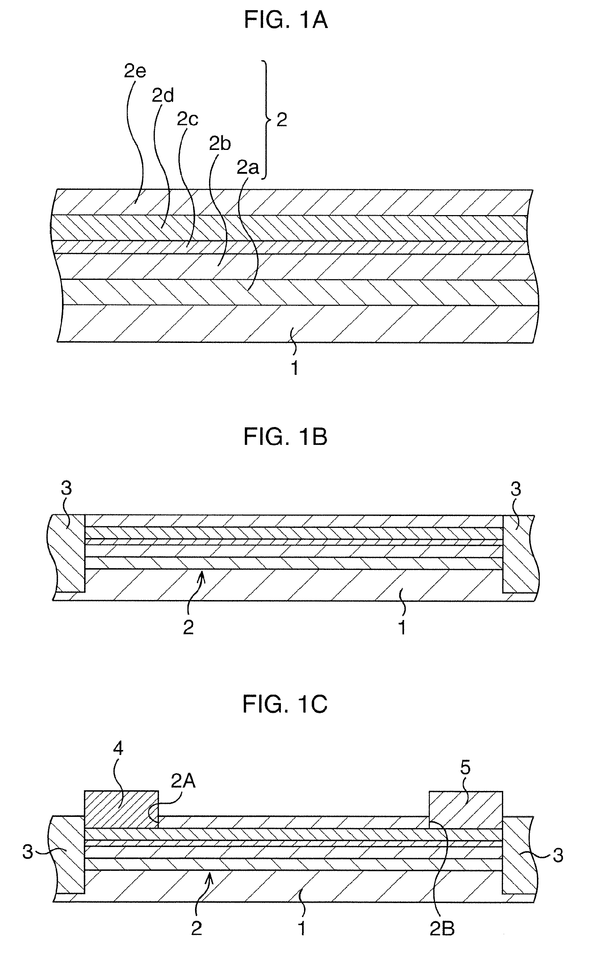

Fig. 1A to Fig. 3B are schematic cross-sectional views illustrating a manufacturing method of AlGaN/GaN · HEMT according to the first embodiment in the order of steps.

First, as illustrated in Fig. 1A, for example, a compound semiconductor layered structure 2 is formed on a semi-insulating SiC substrate 1 as a growth substrate. As the growth substrate, an Si substrate, a sapphire substrate, a GaAs substrate, a GaN substrate, or the like may be used instead of the SiC substrate. Further, as the conductivity of the substrate, whether it is semi-insulating or insulating is not in question.

The compound semiconductor layered structure 2 is structured to have a buffer layer 2a, an electron transit layer 2b, an intermediate layer 2c, an electron supply layer 2d, and a cap layer 2e.

In the completed AlGaN/GaN · HEMT in operation, two-dimensional electron gas (2DEG) occurs in the vicinity of the interface of the electron transit layer 2b with the electron supply layer 2d (exactly the intermediate layer 2c). This 2DEG is generated based on piezoelectric polarization, combined with spontaneous polarization of the electron transit layer 2b and the electron supply layer 2d, due to a strain resulted from a lattice constant difference between the compound semiconductor of the electron transit layer 2b (here, GaN) and the compound semiconductor of the electron supply layer 2d (here, AlGaN).

Specifically, on the SiC substrate 1, the following compound semiconductors are grown by metal organic vapor phase epitaxy (MOVPE) method for example. Instead of the MOVPE method, molecular beam epitaxy (MBE) method or the like may also be used.

On the SiC substrate 1, there are sequentially grown AIN to a thickness of approximately 5 nm, i(intentionally undoped)-GaN to a thickness of approximately 1 µm, i-AlGaN to a thickness of approximately 5 nm, n-AlGaN to a thickness of approximately 30 nm, and n-GaN to a thickness of approximately 3 nm. Thus, the buffer layer 2a, the electron transit layer 2b, the intermediate layer 2c, the electron supply layer 2d, and the cap layer 2e are formed. As the buffer layer 2a, AlGaN may be used instead of AIN, or GaN may be grown by low-temperature growth.

As the growth condition of AIN, GaN, and AlGaN, a mixed gas of trimethylaluminum gas, trimethylgallium gas, and ammonia gas is used as a source gas. The presence/absence of supply and the flow rates of the trimethylaluminum gas as an Al source and the trimethylgallium gas as a Ga source are set appropriately depending on the compound semiconductor layer to be grown. The flow rate of the ammonia gas as a common raw material is approximately 100 sccm to 10 slm. Further, the growth pressure is approximately 50 Torr to 300 Torr, and the growth temperature is approximately 1000°C to 1200°C.

When GaN and AlGaN are grown as n-type, for example an SiH₄ gas containing Si as n-type impurity for example is added to the source gas at a predetermined flow rate, so as to dope Si into GaN and AlGaN. The doping concentration of Si is approximately 1 × 10¹⁸/cm³ to approximately 1 × 10²⁰/cm³, for example approximately 5 × 10¹⁸/cm³.

Subsequently, as illustrated in Fig. 1B, an element isolation structure 3 is formed.

Specifically, for example, argon (Ar) is implanted into an element isolation region of the compound semiconductor layered structure 2. Thus, the element isolation structure 3 is formed in surface layer portions of the compound semiconductor layered structure 2 and the SiC substrate 1. By the element isolation structure 3, an active region is defined on the compound semiconductor layered structure 2.

Note that the element isolation may be performed using an STI (Shallow Trench Isolation) method for example, instead of the aforementioned implanting method. At this time, for example, a chlorine-based etching gas is used for dry etching the compound semiconductor layered structure 2.

Subsequently, as illustrated in Fig. 1C, a source electrode 4 and a drain electrode 5 are formed.

Specifically, first, electrode recesses 2A, 2B are formed in formation scheduled positions (electrode formation scheduled positions) for the source electrode and the drain electrode in the surface of the compound semiconductor layered structure 2.

A resist is applied on the surface of the compound semiconductor layered structure 2. The resist is processed by lithography to form openings in the resist which expose the surface of the compound semiconductor layered structure 2 corresponding to the electrode formation scheduled positions. Thus, a resist mask having these openings is formed.

Using this resist mask, the electrode formation scheduled positions of the cap layer 2e are dry etched and removed until the surface of the electron supply layer 2d is exposed. Thus, the electrode recesses 2A, 2B are formed, which expose the electrode formation scheduled positions of the surface of the electron supply layer 2d. The etching condition is such that, using an inert gas of Ar or the like and a chlorine gas of Cl₂ or the like as an etching gas, for example, the flow rate of Cl₂ is 30 sccm, the pressure thereof is 2Pa, and the RF input power is 20 W. Note that the electrode recesses 2A, 2B may be formed by etching to the middle of the cap layer 2e or may be formed by etching beyond the electron supply layer 2d.

The resist mask is removed by ashing treatment or the like.

A resist mask for forming the source electrode and the drain electrode is formed. Here, for example, an eaves structure two-layer resist is used, which is suitable for vapor deposition method and lift-off method. This resist is applied on the compound semiconductor layered structure 2, and openings for exposing the electrode recesses 2A, 2B are formed. Thus, the resist mask having these openings is formed.

Using this resist mask, Ti/Al for example is deposited as an electrode material by a vapor deposition method for example, on the resist mask including the openings for exposing the electrode recesses 2A, 2B. The thickness of Ti is approximately 20 nm, and the thickness of Al is approximately 200 nm. By the lift-off method, the resist mask and Ti/Al deposited thereon are removed. Thereafter, the SiC substrate 1 is heat treated by temperatures of approximately 400°C to 1000°C, for example approximately 600°C, in a nitrogen atmosphere for example, bringing the remaining Ti/Al into ohmic contact with the electron supply layer 2d. As long as the ohmic contact of Ti/Al with the electron supply layer 2d can be obtained, there may be cases where the heat treatment is unnecessary. Thus, the source electrode 4 and the drain electrode 5 are formed such that the electrode recesses 2A, 2B are embedded by part of the electrode material.

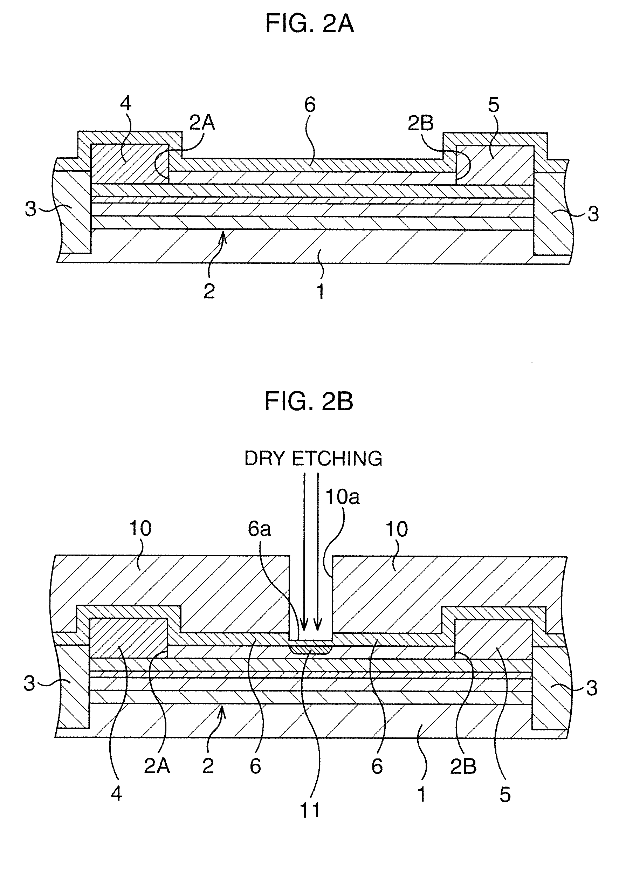

Subsequently, as illustrated in Fig. 2A, a passivation film 6 which protects the surface of the compound semiconductor layered structure 2 is formed.

Specifically, an insulating film, here a single-layer silicon nitride film (SiN film), is deposited with a thickness of approximately 100 nm for example by a plasma CVD method, so as to cover the surface of the compound semiconductor layered structure 2. Thus, the passivation film 6 is formed. As the passivation film 6, a single-layer silicon oxide film (SiO film), a single-layer silicon oxynitride film (SiON film), aluminum oxide (AlO film) or a single-layer aluminum nitride film (AIN film) may be formed instead of the single-layer SiN film. It is also preferred to form a layered film with any two or more layers selected from an SiN film, an SiO film, an SiON film, and an AIN film.

Subsequently, as illustrated in Fig. 2B, the passivation film 6 is dry etched and thinned.

Specifically, first, a resist is applied on the surface of the compound semiconductor layered structure 2. The resist is processed by lithography to form in the resist an opening 10a which exposes the portion corresponding to a formation scheduled position (electrode formation scheduled position) for a gate electrode in the surface of the passivation film 6. Thus, a resist mask 10 having the opening 10a is formed.

Using this resist mask 10, the electrode formation scheduled position of the passivation film 6 is dry etched until the passivation film 6 has a predetermined thickness, thereby thinning the passivation film 6. The thinned portion of the passivation film 6 is referred to as a thinned portion 6a. The dry etching is performed under the etching condition that an etching gas containing fluorine, for example an etching gas containing fluorine based gas such as SF₆, is used, and the fluorine is introduced into the compound semiconductor layered structure 2. The thickness of the thinned portion 6a is desired to be, for example, a value in the range of approximately 4 nm to approximately 50 nm. When it is thinner than approximately 4 nm, there is a concern that escape of nitrogen occurs in the crystal of the compound semiconductor layered structure 2 due to the dry etching. When it is thicker than approximately 50 nm, there is a concern that a desired amount of fluorine of the etching gas is not introduced into the compound semiconductor layered structure 2, and the amount of the thinned portion 6a to be removed by wet etching which will be performed subsequently becomes large, making it difficult to make an opening of desired size. Therefore, by making the thickness of the thinned portion 6a be a value in the range of approximately 4 nm to approximately 50 nm, a desired amount of fluorine can be introduced into the compound semiconductor layered structure 2 without causing escape of nitrogen in the crystal of the compound semiconductor layered structure 2, making it possible to form an opening of desired size by the subsequent wet etching. The region where fluorine is introduced is exemplified as a fluorine introduced region 11 in the compound semiconductor layered structure 2. In this embodiment, for example, dry etching of ICP is performed with bias power of approximately 30 W, leaving the thinned portion 6a with a thickness of approximately 10 nm.

Note that it is possible that the surface of the resist mask 10 becomes hydrophobic by fluorine-based dry etching. In this case, it is preferred to make the surface of the resist mask 10 be hydrophilic in preparation for the subsequent dry etching by lightly ashing the surface of the resist mask 10, or the like after the dry etching.

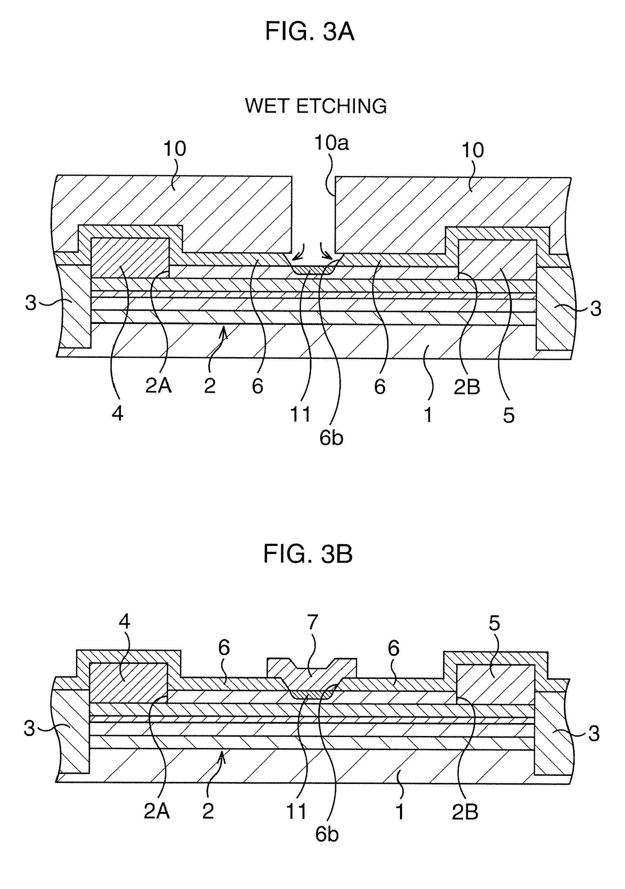

Subsequently, as illustrated in Fig. 3A, in the thinned portion 6a of the passivation film 6, an opening 6b penetrating this portion is formed.

Specifically, using the resist mask 10 continuously, the thinned portion 6a of the passivation film 6 is wet etched until the surface of the compound semiconductor layered structure 2 is exposed. Thus, the opening 6b penetrating the thinned portion 6a is formed. For the wet etching, for example, a buffered hydrofluoric acid is used as an etching solution. The opening 6b has a side wall which is formed in a forward tapered shape by the wet etching. However, since the thickness of the thinned portion 6a is sufficiently thin, the opening has a desired opening diameter.

In this embodiment, in the formation scheduled position for the gate electrode in the passivation film 6, after dry etching is performed to a limit of leaving the thinned portion 6a thinly, the thinned portion 6a is wet etched to form the opening 6b as a through hole. By performing this two-stage etching, without causing escape of nitrogen in the crystal of the compound semiconductor layered structure 2, a desired amount of fluorine can be introduced into the compound semiconductor layered structure 2, and it is possible to form the opening 6b of desired size.

The resist mask 10 is removed by ashing treatment, wet treatment using a predetermined chemical solution, or the like.

Subsequently, as illustrated in Fig. 3B, a gate electrode 7 is formed.

Specifically, first, a resist mask for forming the gate electrode is formed. Here, for example, an eaves structure two-layer resist suitable for vapor deposition method and lift-off method is used. This resist is applied on the passivation film 6, and an opening which exposes the portion of the opening 6b of the passivation film 6 is formed. Thus, the resist mask having this opening is formed.

Using this resist mask, Ni/Au as an electrode material for example is deposited by a vapor deposition method for example on the resist mask including the opening which exposes the portion of the opening 6b of the passivation film 6. The thickness of Ni is approximately 10 nm, and the thickness of Au is approximately 300 nm. By the lift-off method, the resist mask and Ni/Au deposited thereon are removed. Thus, the gate electrode 7 is formed on the passivation film 6 so as to embed the opening 6b by part of the electrode material.

Thereafter, through steps such as forming wirings connected to the source electrode 4, the drain electrode 5, and the gate electrode 7, the Schottky type AlGaN/GaN · HEMT according to this embodiment is formed.

The effect exhibited by the Schottky type AlGaN/GaN · HEMT according to this embodiment will be described based on comparison with a conventional Schottky type AlGaN/GaN · HEMT.

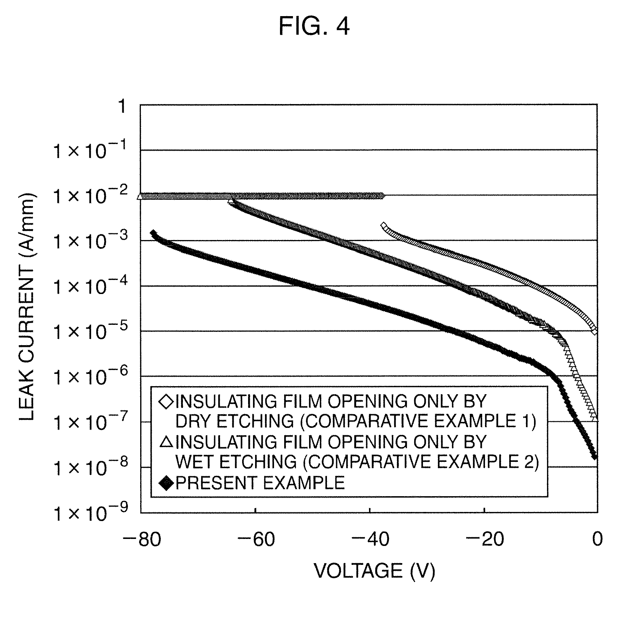

Fig. 4 is a characteristic diagram illustrating results of checking leak current which occurs with respect to the Schottky type AlGaN/GaN · HEMT according to this embodiment and comparative examples 1, 2. In the comparative example 1, there is illustrated leak current of a Schottky type AlGaN/GaN · HEMT in which only dry etching is performed as the etching for forming the through hole in the formation scheduled position for the gate electrode in the passivation film. In the comparative example 2, there is illustrated leak current of a Schottky type AlGaN/GaN · HEMT in which only wet etching is performed as the etching for forming the through hole in the formation scheduled position for the gate electrode in the passivation film.

As illustrated, occurrence of relatively large leak current was recognized in the comparative examples 1, 2. On the other hand, in this embodiment, it was recognized that leak current largely decreases as compared to the comparative examples 1, 2, and withstand voltage improves also.

As described above, according to this embodiment, a highly reliable, high withstand voltage AlGaN/GaN · HEMT in which leak current is suppressed can be achieved even though the desired minute opening 6b is formed in the passivation film 6 on the compound semiconductor layered structure 2.

### -Second Embodiment-

In this embodiment, a GaN-based semiconductor Schottky barrier diode (GaN-SBD) is disclosed as the compound semiconductor device.

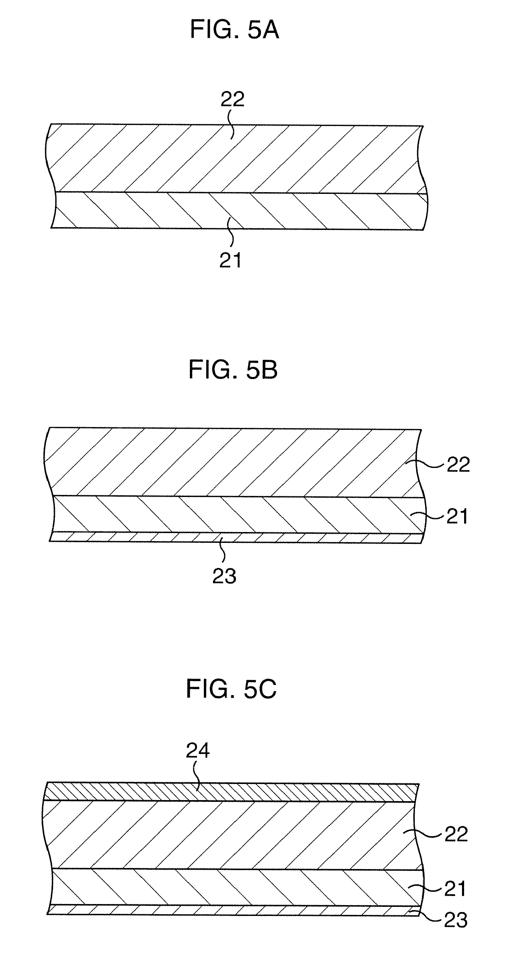

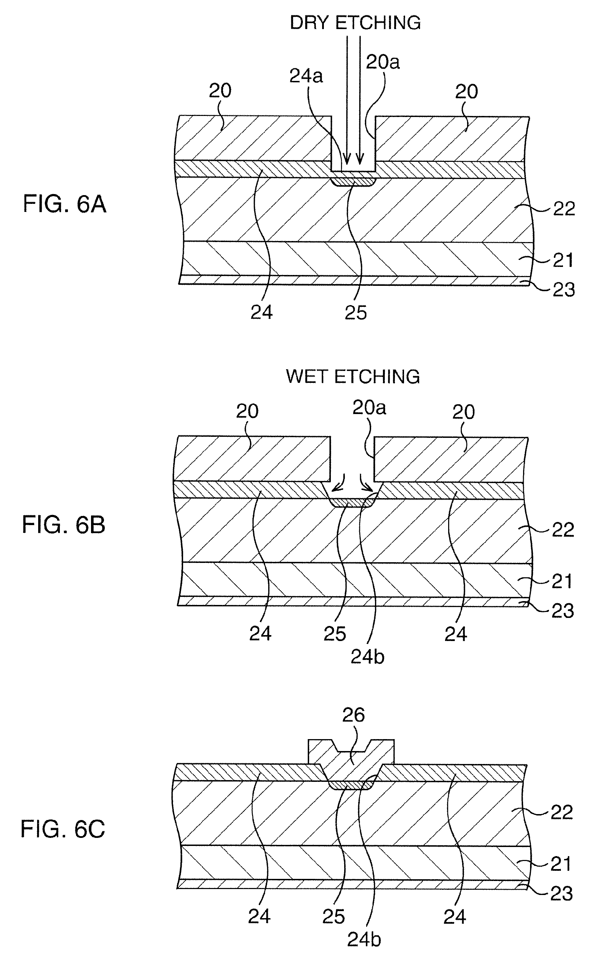

Fig. 5A to Fig. 5C and Fig. 6A to Fig. 6C are schematic cross-sectional views illustrating a manufacturing method of the GaN-SBD according to the second embodiment in the order of steps.

First, as illustrated in Fig. 5A, for example, a compound semiconductor layer 22 is formed on the surface of a GaN substrate 21 as a growth substrate. As the growth substrate, an n-type conductivity Si substrate, SiC substrate, GaAs substrate, or the like may be used instead of the GaN substrate.

The compound semiconductor layer 22 is formed by growing an n-GaN epitaxial layer by the MOVPE method, similarly to the case where the compound semiconductor layered structure 2 is formed in the first embodiment. The n-GaN epitaxial layer has a predetermined thickness, made as n-type by doping n-type impurities, for example Si, and the thickness and doping concentration thereof are arbitrary depending on characteristics desired in GaN-SBD. For example, the n-GaN epitaxial layer has a thickness of approximately 10 µm and doping concentration of approximately 5 × 10¹⁶/cm³.

Subsequently, as illustrated in Fig. 5B, a cathode electrode 23 is formed on a rear surface of the GaN substrate 21.

Specifically, on the rear surface of the GaN substrate 21, there are sequentially formed Ti for example with a thickness of approximately 20 nm and Al for example with a thickness of approximately 200 nm by the vapor deposition method for example. Then, the GaN substrate 21 is heat treated at approximately 550°C, thereby bringing the GaN substrate 21 into ohmic contact with the aforementioned layered film. Thus, the cathode electrode 23 is formed on the rear surface of the GaN substrate 21.

A passivation film 24 which protects the surface of the compound semiconductor layer 22 is formed.

Specifically, an insulating film, here a single-layer silicon nitride film (SiN film), is deposited with a thickness of approximately 100 nm for example by a plasma CVD method, so as to cover the surface of the compound semiconductor layer 22. Thus, the passivation film 24 is formed. As the passivation film 24, a single-layer silicon oxide film (SiO film), a single-layer silicon oxynitride film (SiON film), a single-layer aluminum oxide film (AIO film) or a single-layer aluminum nitride film (AIN film) may be formed instead of the single-layer SiN film. It is also preferred to form a layered film with any two or more layers selected from an SiN film, an SiO film, an SiON film, and an AIN film.

Subsequently, as illustrated in Fig. 6A, the passivation film 24 is dry etched and thinned.

Specifically, first, a resist is applied on the surface of the compound semiconductor layer 22. The resist is processed by lithography to form in the resist an opening 20a which exposes the portion corresponding to a formation scheduled position (electrode formation scheduled position) for an anode electrode in the surface of the passivation film 24. Thus, a resist mask 20 having the opening 20a is formed.

Using this resist mask 20, the electrode formation scheduled position of the passivation film 24 is dry etched until the passivation film 24 has a predetermined thickness, thereby thinning the passivation film 24. The thinned portion of the passivation film 24 is referred to as a thinned portion 24a. The dry etching is performed under the etching condition that an etching gas containing fluorine, for example an etching gas containing fluorine based gas such as SF₆, is used, and the fluorine is introduced into the compound semiconductor layer 22. The thickness of the thinned portion 24a is desired to be, for example, a value in the range of approximately 4 nm to approximately 50 nm. When it is thinner than approximately 4 nm, there is a concern that escape of nitrogen occurs in the crystal of the compound semiconductor layer 22 due to the dry etching. When it is thicker than approximately 50 nm, there is a concern that a desired amount of fluorine of the etching gas is not introduced into the compound semiconductor layer 22, and the amount of the thinned portion 24a to be removed by wet etching which will be performed subsequently becomes large, making it difficult to make an opening of desired size. Therefore, by making the thickness of the thinned portion 24a be a value in the range of approximately 4 nm to approximately 50 nm, a desired amount of fluorine can be introduced into the compound semiconductor layer 22 without causing escape of nitrogen in the crystal of the compound semiconductor layer 22, making it possible to form an opening of desired size by the subsequent wet etching. The region where fluorine is introduced is exemplified as a fluorine introduced region 25 in the compound semiconductor layer 22. In this embodiment, for example, dry etching of ICP is performed with bias power of approximately 30 W, leaving the thinned portion 24a with a thickness of approximately 10 nm.

Note that it is possible that the surface of the resist mask 20 becomes hydrophobic by fluorine-based dry etching. In this case, it is preferred to make the surface of the resist mask 20 be hydrophilic in preparation for the subsequent dry etching by lightly ashing the surface of the resist mask 20, or the like after the dry etching.

Subsequently, as illustrated in Fig. 6B, in the thinned portion 24a of the passivation film 24, an opening 24b penetrating this portion is formed.

Specifically, using the resist mask 20 continuously, the thinned portion 24a of the passivation film 24 is wet etched until the surface of the compound semiconductor layer 22 is exposed. Thus, the opening 24b penetrating the thinned portion 24a is formed. For the wet etching, for example, a buffered hydrofluoric acid is used as an etching solution. The opening 24b has a side wall which is formed in a forward tapered shape by the wet etching. However, since the thickness of the thinned portion 24a is sufficiently thin, the opening has a desired opening diameter.

In this embodiment, in the formation scheduled position for the anode electrode in the passivation film 24, after dry etching is performed to a limit of leaving the thinned portion 24a thinly, the thinned portion 24a is wet etched to form the opening 24b as a through hole. By performing this two-stage etching, without causing escape of nitrogen in the crystal of the compound semiconductor layer 22, a desired amount of fluorine can be introduced into the compound semiconductor layer 22, and it is possible to form the opening 24b of desired size.

The resist mask 20 is removed by ashing treatment, wet treatment using a predetermined chemical solution, or the like.

Subsequently, as illustrated in Fig. 6C, an anode electrode 26 is formed.

Specifically, first, a resist mask for forming the anode electrode is formed. Here, for example, an eaves structure two-layer resist suitable for vapor deposition method and lift-off method is used. This resist is applied on the passivation film 24, and each opening which exposes the portion of the opening 24b of the passivation film 24 is formed. Thus, the resist mask having this opening is formed.

Using this resist mask, Pt as an electrode material for example is deposited with a thickness of approximately 300 nm by a vapor deposition method for example on the resist mask including the opening which exposes the portion of the opening 24b of the passivation film 24. By the lift-off method, the resist mask and Pt deposited thereon are removed. Thus, the anode electrode 26 is formed on the passivation film 24 so as to embed the opening 24b by part of the electrode material.

Thereafter, through steps such as electrically connecting the cathode electrode 23 and the anode electrode 26, the GaN-SBD according to this embodiment is formed.

As described above, according to this embodiment, a highly reliable, high withstand voltage GaN-SBD in which leak current is suppressed can be achieved even though the desired minute opening 24b is formed in the passivation film 24 on the compound semiconductor layer 22. Although the GaN-SBD having a vertical structure is described above, this embodiment may be applied to a GaN-SBD having a horizontal structure. For the horizontal GaN-SBD, the substrate may be insulating or semi-insulating, and a sapphire substrate may also be used.

### -Third Embodiment-

In this embodiment, a PFC (Power Factor Correction) circuit is disclosed, which has one or both of the AlGaN/GaN · HEMT produced according to the first embodiment and the GaN-SBD produced according to the second embodiment.

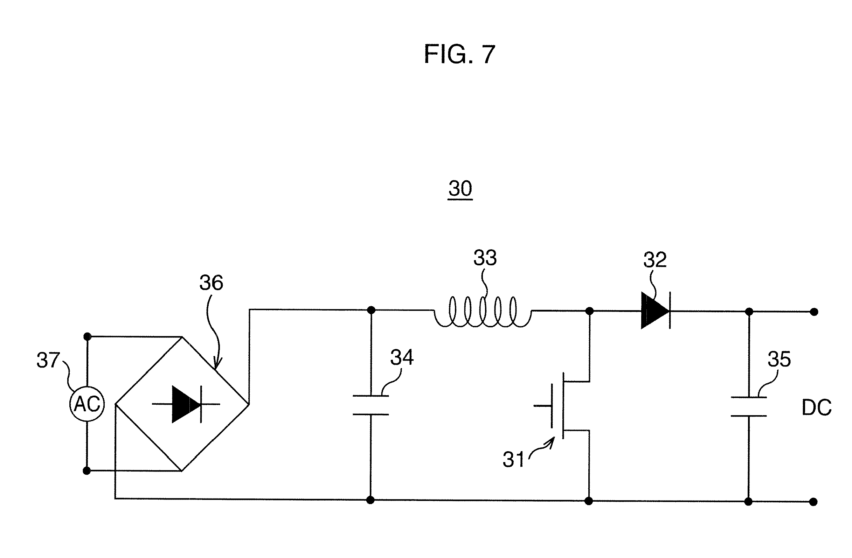

Fig. 7 is a connection diagram illustrating a PFC circuit according to the third embodiment.

The PFC circuit 30 is structured to have a switch element (transistor) 31, a diode 32, a choke coil 33, capacitors 34, 35, a diode bridge 36, and an alternating-current power supply (AC) 37. The AlGaN/GaN · HEMT produced according to the first embodiment is applied to the switch element 31. Alternatively, the GaN-SBD produced according to the second embodiment is applied to the diode 32. Further alternatively, the AlGaN/GaN · HEMT produced according to the first embodiment is applied to the switch element 31, and the GaN-SBD produced according to the second embodiment is applied to the diode 32.

Note that the GaN-SBD produced according to the second embodiment may also be applied to the diode bridge 36.

In the PFC circuit 30, the drain electrode of the switch element 31 is connected with the anode terminal of the diode 32 and one terminal of the choke coil 33. The source electrode of the switch element 31 is connected with one terminal of the capacitor 34 and one terminal of the capacitor 35. The other terminal of the capacitor 34 is connected with the other terminal of the choke coil 33. The other terminal of the capacitor 35 is connected with the cathode terminal of the diode 32. Between the both terminals of the capacitor 34, the AC 37 is connected via the diode bridge 36. Between the both terminals of the capacitor 35, a direct-current power supply (DC) is connected.

In this embodiment, a highly reliable, high withstand voltage AlGaN/GaN · HEMT, in which leak current is suppressed even though the desired minute opening 6b is formed in the passivation film 6 on the compound semiconductor layered structure 2, is applied to the PFC circuit 30. Further, a highly reliable, high withstand voltage GaN-SBD, in which leak current is suppressed even though the desired minute opening 24b is formed in the passivation film 24 on the compound semiconductor layer 22, is applied to the PFC circuit 30. Thus, a highly reliable PFC circuit 30 is achieved.

### -Fourth Embodiment-

In this embodiment, a power supply device is disclosed, which has one or both of the AlGaN/GaN · HEMT produced according to the first embodiment and the GaN-SBD produced according to the second embodiment.

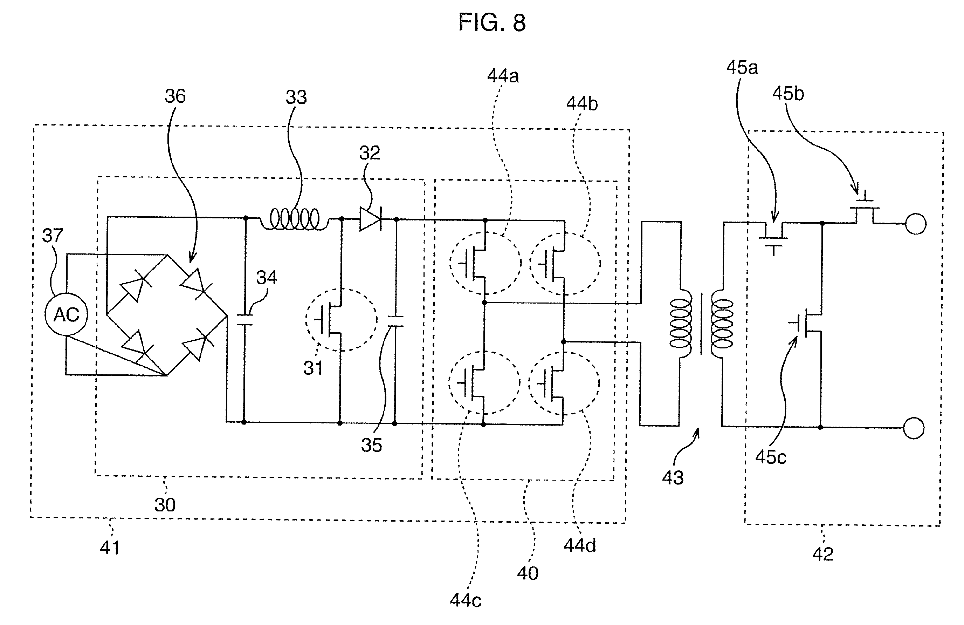

Fig. 8 is a connection diagram illustrating a schematic structure of a power supply device according to the fourth embodiment.

The power supply device according to this embodiment is structured to have a high-voltage primary side circuit 41 and a low-voltage secondary side circuit 42, and a transformer 43 disposed between the primary side circuit 41 and the secondary side circuit 42.

The primary side circuit 41 has a PFC circuit 30 according to the third embodiment, and an inverter circuit, for example a full bridge inverter circuit 40, connected between both the terminals of the capacitor 35 of the PFC circuit 30. The full bridge inverter circuit 40 is structured to have plural (here, four) switch elements 44a, 44b, 44c, 44d.

The secondary side circuit 42 is structured to have plural (here, three) switch elements 45a, 45b, 45c.

In this embodiment, the switch element 31 of the PFC circuit 30 and the switch elements 44a, 44b, 44c, 44d of the full bridge inverter circuit 40, which form the primary side circuit 41, are the AlGaN/GaN · HEMT according to the first embodiment. Alternatively, the diode 32 of the PFC circuit 30 is the GaN-SBD according to the second embodiment, and the switch elements 44a, 44b, 44c, 44d of the full bridge inverter circuit 40 are the AlGaN/GaN · HEMT according to the first embodiment. Further alternatively, the switch element 31 of the PFC circuit 30 and the switch elements 44a, 44b, 44c, 44d of the full bridge inverter circuit 40 are the AlGaN/GaN · HEMT according to the first embodiment, and the diode 32 of the PFC circuit 30 is the GaN-SBD according to the second embodiment.

On the other hand, the switch elements 45a, 45b, 45c of the secondary side circuit 42 are an ordinary MIS · FET using silicon.

In this embodiment, the PFC circuit 30 according to the third embodiment is applied to the power supply device. Accordingly, a highly reliable power supply device with high power is achieved.

### -Fifth Embodiment-

In this embodiment, a high frequency amplifier having an AlGaN/GaN · HEMT produced according to the first embodiment is disclosed.

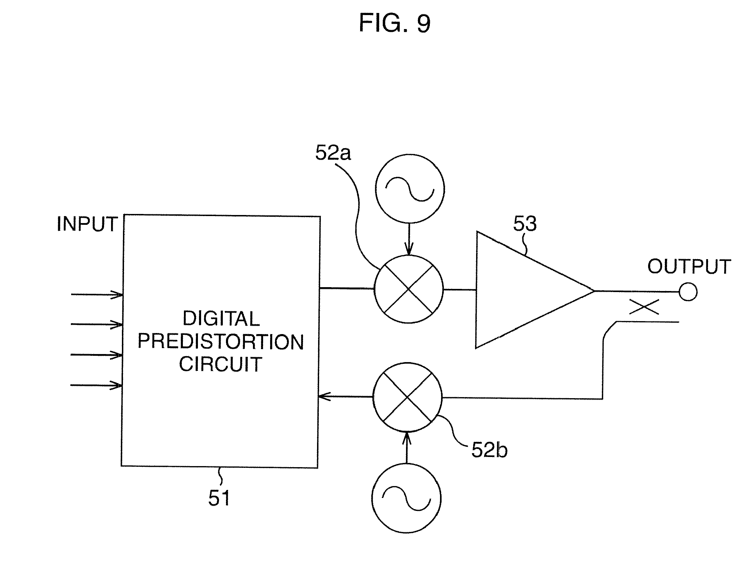

Fig. 9 is a connection diagram illustrating a schematic structure of a high frequency amplifier according to the fifth embodiment.

The high frequency amplifier according to this embodiment is structured to have a digital predistortion circuit 51, mixers 52a, 52b, and a power amplifier 53.

The digital predistortion circuit 51 compensates non-linear distortion of an input signal. The mixer 52a mixes the input signal, in which non-linear distortion is compensated, with an alternating-current signal. The power amplifier 53 amplifies the input signal mixed with the alternating-current signal, and has the AlGaN/GaN · HEMT according to the first embodiment. Note that in the structure in Fig. 9, for example by switching the switches, the signal on the output side is mixed with the alternating-current signal in the mixer 52b, and can be outputted to the digital predistortion circuit 51.

In this embodiment, a highly reliable, high withstand voltage AlGaN/GaN · HEMT, in which leak current is suppressed even though the desired minute opening 6b is formed in the passivation film 6 on the compound semiconductor layered structure 2, is applied to the high frequency amplifier. Thus, a highly reliable high frequency amplifier is achieved.

### -Other Embodiments-

In the first and third to fifth embodiments, the AlGaN/GaN · HEMT is exemplified as the compound semiconductor device. The compound semiconductor device may be applied to the following HEMTs besides the AlGaN/GaN · HEMT.

### -Another HEMT example 1

In this example, an InAIN/GaN · HEMT is disclosed as the compound semiconductor device.

InAIN and GaN are compound semiconductors whose lattice constant can be made close by their compositions. In this case, in the above-described first and third to fifth embodiments, the electron transit layer is formed by i-GaN, the intermediate layer by AIN, the electron supply layer by n-InAIN, and the cap layer by n-GaN. Further, piezoelectric polarization barely occurs in this case, and thus the two-dimensional electron gas mainly occurs by spontaneous polarization of the InAIN.

According to this example, similarly to the above-described AlGaN/GaN · HEMT, a highly reliable, high withstand voltage InAIN/GaN · HEMT is achieved, in which leak current is suppressed even though the desired minute opening is formed in the passivation film on the compound semiconductor layered structure.

### -Another HEMT example 2

In this example, an InAlGaN/GaN · HEMT is disclosed as the compound semiconductor device.

GaN and InAlGaN are compound semiconductors where the latter can be made smaller in lattice constant than the former by their compositions. In this case, in the first and third to fifth embodiments, the electron transit layer is formed by i-GaN, the intermediate layer by i-InAlGaN, the electron supply layer by n-InAlGaN, and the cap layer by n-GaN.

According to this example, similarly to the above-described AlGaN/GaN · HEMT, a highly reliable, high withstand voltage InAlGaN/GaN · HEMT is achieved, in which leak current is suppressed even though the desired minute opening is formed in the passivation film on the compound semiconductor layered structure.

According to the above-described embodiments, a highly reliable, high withstand voltage compound semiconductor device is achieved, in which leak current is suppressed even though the desired minute opening is formed in the insulating film on the compound semiconductor layered structure.

While certain embodiments have been described, these embodiments have been presented by way of example only, and it will be understood that variations and modifications to these embodiments may be made without departing from the scope of the invention as defined by the appended claims. Furthermore, it will be understood that features of an embodiment may be combined with any other features of any of the embodiments to describe additional embodiments.

## Claims

1. A manufacturing method for a compound semiconductor device, the method comprising:
forming an insulating film (6) on a compound semiconductor layer (2);
thinning a predetermined portion (6a) of the insulating film (6) by dry etching; and
penetrating a thinned predetermined portion (6b) of the insulating film (6) by wet etching.

2. The manufacturing method for the compound semiconductor device according to claim 1, wherein
the dry etching uses an etching gas which contains fluorine.

3. The manufacturing method for the compound semiconductor device according to claim 2, wherein
the dry etching is performed under an etching condition that fluorine is introduced into the compound semiconductor layer (2).

4. The manufacturing method for the compound semiconductor device according to any one of claims 1 to 3, wherein
the dry etching thins the predetermined portion (6a) of the insulating film(6) to a thickness in the range of 4 nm to 50 nm.

5. The manufacturing method for the compound semiconductor device according to any one of claims 1 to 4, wherein
the insulating film (6) is a single layer film of one type selected from a silicon nitride, a silicon oxide, a silicon oxynitride, an aluminum oxide and an aluminum nitride, or a layered film with layers of any two or more types selected therefrom.

6. The manufacturing method for the compound semiconductor device according to any one of claims 1 to 5, further comprising
forming an electrode in a predetermined portion (6b) penetrated in the insulating film (6).

7. The manufacturing method for the compound semiconductor device according to claim 6, wherein
the electrode is a gate electrode (7).

8. The manufacturing method for the compound semiconductor device according to claim 6, wherein
the electrode is an anode electrode (26).

9. A compound semiconductor device, comprising:
a compound semiconductor layer (2),
an insulating film (6) which is formed on the compound semiconductor layer (2) and has a through hole (6b); and
an electrode formed in the through hole (6b), wherein
the compound semiconductor layer (2) has a fluorine containing region (11) which contains fluorine in a portion under the electrode.

10. The compound semiconductor device according to claim 9, wherein
the insulating film (6) is a single layer film of one type selected from a silicon nitride, a silicon oxide, a silicon oxynitride, an aluminum oxide and an aluminum nitride, or a layered film with layers of any two or more types selected therefrom.

11. The compound semiconductor device according to claim 9 or 10, wherein the electrode is a gate electrode (7).

12. The compound semiconductor device according to claim 9 or 10, wherein the electrode is an anode electrode (26).

13. A power supply circuit comprising a transformer (43), and a high-voltage circuit(41) and a low-voltage circuit (42) with the transformer (43) being interposed therebetween, wherein:
the high-voltage circuit (41) has a transistor and a diode;
at least one of the transistor and the diode comprises:
a compound semiconductor layer (2),
an insulating film (6) which is formed on the compound semiconductor layer (2) and has a through hole (6b), and
an electrode (7) formed in the through hole (6b); and
the compound semiconductor layer (2) has a fluorine containing region (11) which contains fluorine in a portion under the electrode (7).

14. A high frequency amplifier which amplifies and outputs an inputted high frequency voltage, the high frequency amplifier having a transistor, wherein:
the transistor comprises:
a compound semiconductor layer (2),
an insulating film (6) which is formed on the compound semiconductor layer (2) and has a through hole (6b), and
an electrode (7) formed in the through hole(6b); and
the compound semiconductor layer (2) has a fluorine containing region (11) which contains fluorine in a portion under the electrode (7).
